# EUROPÄISCHE PATENTSCHRIFT

(11) **EP 1 950 807 B1**
(45) Veröffentlichungstag und Bekanntmachung des Hinweises auf die Patenterteilung: **06.05.2009**
(21) Anmeldenummer: 08000992.1
(22) Anmeldetag: 19.01.2008
(51) Int. Cl.: H01L 25/07

(54) **Leistungshalbleitermodul mit Druckkörper**
Power semiconductor module with pressure body
Module semi-conducteur de puissance doté d'un corps de pression

(30) Priorität: 24.01.2007 DE 102007003587
(43) Veröffentlichungstag der Anmeldung: 30.07.2008
(73) Patentinhaber: SEMIKRON Elektronik GmbH & Co. KG, 90431 Nürnberg (DE)
(72) Erfinder: Hager, Ludwig, 90491 Nürnberg (DE); Moser, Herwig, 91301 Forchheim (DE)

(56) Entgegenhaltungen:
- EP-A- 1 263 045
- DE-A1- 19 530 264
- FR-A- 2 395 603

## Beschreibung

Die Erfindung beschreibt ein Leistungshalbleitermodul in Druckkontaktausführung zur Anordnung auf einem Kühlbauteil. Einen Ausgangspunkt der Erfindung bilden Leistungshalbleitermodule wie sie beispielhaft aus der DE 197 19 703 A1 und der nicht vorveröffentlichten 10 2006 006 423 bekannt sind.

Derartige Leistungshalbleitermodule bestehen nach dem Stand der Technik aus einem Gehäuse mit mindestens einem darin angeordneten elektrisch isolierenden Substrat vorzugsweise zur direkten Montage auf einem Kühlbauteil. Das Substrat seinerseits besteht aus einem Isolierstoffkörper mit einer Mehrzahl darauf befindlicher gegeneinander isolierter metallischer Verbindungsbahnen und hierauf befindlichen und mit diesen Verbindungsbahnen schaltungsgerecht verbundenen Leistungshalbleiterbauelementen. Weiterhin weisen die bekannten Leistungshalbleitermodule Anschlusselemente für externe Last- und Hilfsanschlüsse sowie im Inneren angeordnete Verbindungselemente auf. Diese Verbindungselemente für schaltungsgerechte Verbindungen im Inneren des Leistungshalbleitermoduls sind meist als Drahtbondverbindungen ausgebildet.

Ebenfalls bekannt sind Druck kontaktierte Leistungshalbleitermodule, wie sie in der DE 10 2006 006 423 offenbart sind. Das Leistungshalbleitermodul gemäß dieser Druckschrift weist eine Druckkontaktausführung, zur Anordnung auf einem Kühlbauteil auf. Weiterhin ist hierin mindestens ein Substrat mit Leistungshalbleiterbauelementen angeordnet. Das Leistungshalbleitermodul weist zudem ein Gehäuse und nach außen führenden Last- und Steueranschlusselementen auf. Das Substrat, beispielhaft ein DCB-Substrat, weist einen Isolierstoffkörper (52) auf, auf dessen erster dem Inneren des Leistungshalbleitermoduls zugewandten Hauptfläche Leiterbahnen mit Lastpotential angeordnet sind.

Diese Lastanschlusselemente sind jeweils als Metallformkörper mit mindestens einer externen Kontakteinrichtung, einem bandartigen Abschnitt und mit von diesem ausgehenden Kontaktfüßen ausgebildet. Der jeweilige bandartige Abschnitt ist parallel zur Substratoberfläche und von dieser beabstandet angeordnet. Die Kontaktfüße reichen von dem bandartigen Abschnitt zum Substrat und kontaktieren dieses schaltungsgerecht. Zur elektrischen Isolation und Druckweiterleitung zwischen den einzelnen Lastanschlusselementen weisen diese im Bereich der jeweiligen bandartigen Abschnitte jeweils eine elastische Zwischenlage auf.

Weiterhin sind aus der FR-A-2395603 Halbleiterbauelemente mit mehreren Halbleiterelementen bekannt, welche mittels Kontaktstreifen und jeweils einer zugeordneten Zuführungselektrode elektrisch leitend verbunden sind und jene Zuführungselektroden mittels Federn, welche nach Außen die Anschlusselemente des Halbleiterbauelements bilden, an die Halbleiterelemente angepresst sind

Der Erfindung liegt die Aufgabe zugrunde ein Leistungshalbleitermodul in Druckkontaktausführung vorzustellen, wobei die Einleitung des Drucks auf die jeweiligen Lastanschlusselemente zu deren Kontaktierung mit den Leiterbahnen des Substrats homogen ausgebildet ist.

Die Aufgabe wird erfindungsgemäß gelöst, durch die Maßnahmen der Merkmale des Anspruchs 1. Bevorzugte Ausführungsformen sind in den Unteransprüchen beschrieben.

Der erfinderische Gedanke geht aus von einer Anordnung eines Leistungshalbleitermoduls in Druckkontaktausführung mit mindestens einem Druckkörper auf einem Kühlbauteil mit mindestens einem Substrat, hierauf angeordneten Leistungshalbleiterbauelementen, beispielhaft bipolaren Transistoren, einem Gehäuse und nach außen führenden Last- und Steueranschlusselementen. Das Substrat selbst weist einen Isolierstoffkörper auf und auf dessen erster, dem Inneren des Leistungshalbleitermoduls zugewandten Hauptfläche Leiterbahnen mit Lastpotential. Weiterhin weist das Substrat vorzugsweise auch mindestens eine Leiterbahn mit Steuerpotential zu Ansteuerung der Leistungshalbleiterbauelemente auf.

Die Lastanschlusselemente des Leistungshalbleitermoduls sind jeweils ausgebildet als Metallformkörper mit einer Kontakteinrichtung, einem bandartigen Abschnitt und mit einer Mehrzahl von diesem ausgehenden Kontaktfüßen. Die jeweiligen bandartige Abschnitte sind parallel zur Substratoberfläche und von dieser beabstandet angeordnet, Die Kontaktfüße, die von dem bandartigen Abschnitt ausgehen reichen zum Substrat und bilden dort schaltungsgerecht die Kontakte der Lastanschlüsse aus. Vorzugsweise kontaktieren sie hierzu auf dem Substrat die Leiterbahnen mit Lastpotential, alternativ auch direkt die Leistungshalbleiterbauelemente.

Weiterhin ist mindestens ein Druckkörper zwischen der Druckeinrichtung (70) und einem weiteren Lastanschlusselement angeordnet, wobei erfindungsgemäß ein Teil dieses Druckkörpers (80) durch das erste Lastanschlusselement (40) hindurch reicht und Druck auf eine Druckaufnahmestelle (424, 444) des zugeordneten weiteren Lastanschlusselement (42, 44) ausbildet. Hierbei ist das weitere Lastanschlusselement von dem ersten Lastanschlusselement beabstandet angeordnet.

Diese Ausgestaltung weist den Vorteil auf, dass die einzelnen Lastanschlusselemente nicht starr sondern flexibel zueinander angeordnet sind und dadurch die Kontaktsicherheit jeder einzelnen Kontakteinrichtung für sich sichergestellt ist und nicht von den jeweils anderen Kontakteinrichtungen abhängig ist. Somit erweisen sich thermische Einflüsse, wie auch Fertigungstoleranzen in der Länge der jeweiligen Kontaktfüße der einzelnen Lastanschlusselemente zueinander als nicht wesentlich für die elektrische Kontaktsicherheit.

Die erfinderische Lösung wird an Hand der Ausführungsbeispiele der Fig. 1 bis 5 weiter erläutert.
Fig. 1 zeigt einen Schnitt durch ein Leistungshalbleitermodul nach dem Stand der Technik.
Fig. 2 zeigt einen Schnitt durch eine erste Ausgestaltung eines erfindungsgemäßen Leistungshalbleitermoduls.
Fig. 3 zeigt einen Ausschnitt gemäß Fig. 2 einer zweiten Ausgestaltung eines erfindungsgemäßen Leistungshalbleitermoduls.
Fig. 4 zeigt einen Ausschnitt gemäß Fig. 2 einer dritten Ausgestaltung eines erfindungsgemäßen Leistungshalbleitermoduls.
Fig. 5 zeigt in dreidimensionaler Darstellung ein erfindungsgemäßes Leistungshalbleitermodul.

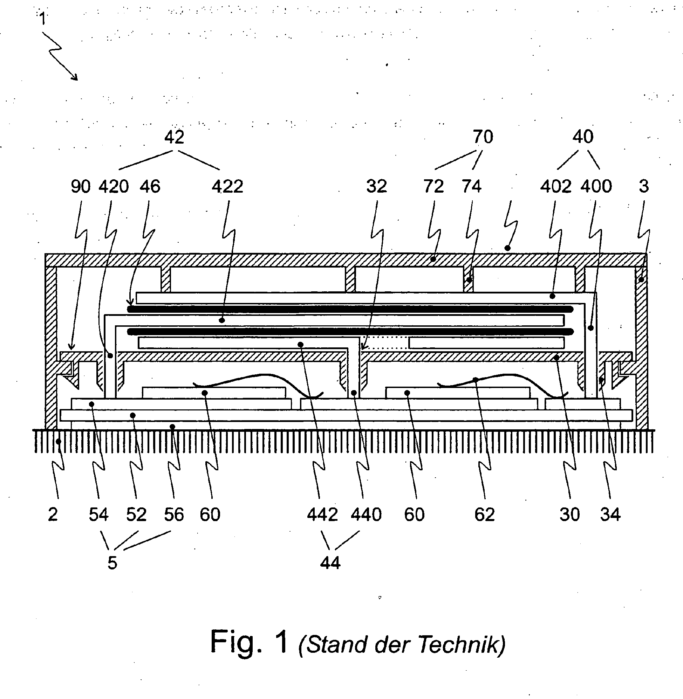

Fig. 1 zeigt einen Schnitt durch ein Leistungshalbleitermodul (1) nach dem Stand der Technik. Dieses weist ein Gehäuse (3) mit einem rahmenartigen Gehäuseteil auf, der mit dem Kühlbauteil (2) der Anordnung verbunden ist. Der rahmenartige Gehäuseteil umschließt hierbei das mindestens eine Substrat (5). Dieses wiederum weist einen Isolierstoffkörper (52), vorzugsweise eine Isolierkeramik, wie Aluminiumoxid oder Aluminiumnitrit auf.

Auf der, dem Inneren des Leistungshalbleitermoduls (1) zugewandten, ersten Hauptfläche weist das Substrat (5) eine in sich strukturierte Metallkaschierung auf. Die einzelnen Abschnitte dieser vorzugsweise als Kupferkaschierung ausgestalteten Metallkaschierung bilden hierbei die Leiterbahnen (54) des Leistungshalbleitermoduls (1) aus. Die zweite Hauptfläche des Substrats (5) weist gemäß dem Stand der Technik eine nicht strukturierte Kupferkaschierung (58) auf.

Auf den Leiterbahnen (54) des Substrats (5) sind steuerbare und / oder ungesteuerte Leistungshalbleiterbauelemente (60) wie beispielhaft IGBTs (insulated gate bipolar Transistor) mit jeweils antiparallel geschalteten Freilaufdioden, oder MOS-FETs angeordnet. Diese sind schaltungsgerecht mit weiteren Leiterbahnen (54), beispielhaft mittels Drahtbondverbindungen (62), verbunden.

Die Lastanschlusselemente (40, 42, 44) mit den verschiedenen notwendigen Potentialen dienen der externen Verbindung der leistungselektronischen Schaltung im Inneren des Leistungshalbleitermoduls (1). Hierzu sind die Lastanschlusselemente (40, 42, 44) als Metallformkörper ausgebildet, die je einen bandartigen Abschnitt (402, 422, 442) parallel zur Substratoberfläche aufweisen. Die bandartigen Abschnitte (402, 422, 442) bilden hierbei einen Stapel, wobei die bandartigen Abschnitte der einzelnen Lastanschlusselemente (40, 42, 44) jeweils mittels einer elastischen Zwischenlage (46) hier einem Silikonkissen voneinander beabstandet und gegeneinander elektrisch isoliert sind.

Es ist besonders bevorzugt, wenn diese Silikonkissen (46) mit den bandartigen Abschnitten verklebt sind, da somit der Stapel (4) als eine Montageeinheit ausgebildet ist. Notwendige Hilfsanschlusselemente sind aus Gründen der Übersichtlichkeit in dieser Schnittzeichnung nicht dargestellt.

Vorzugsweise weist das Leistungshalbleitermodul (1) eine als Isolierstoffformkörper (30) ausgebildete Zwischenlage zwischen dem Stapel der bandartigen Abschnitte (402, 422, 442) der Lastanschlusselemente (40, 42, 44) und dem Substrat (5) auf. Der Isolierstoffformkörper (30) weist Ausnehmungen (32) zur Durchführung der Kontaktfüße (400, 420, 440) des Stapels auf.

Die Druckeinrichtung (70) zur thermischen Verbindung des Leistungshalbleitermoduls (1) mit dem Kühlbauteil (2) und gleichzeitig zur elektrischen Kontaktierung der Lastanschlusselemente (40, 42, 44) mit den Leiterbahnen (54) des Substrats (5) wird gebildet durch ein Druckelement (72) zum Druckaufbau auf den Stapel. Hierzu weist das Druckelement Druckfinger (74) nach dem Stand der Technik auf. Es kann auch bevorzugt sein, wenn zwischen dem Druckelement (72) mit flächiger Unterseite und dem Stapel (4) eine weitere elastische Schicht gleicher Ausgestaltung der Zwischenlage (46) angeordnet ist.

Das Druckelement (72) kann weiterhin gemäß dem Stand der Technik als Kunststoffformkörper mit geeigneter innen liegender Metallseele und /oder weiteren Versteifungsstrukturen ausgeführt sein. Es ist ebenso bevorzugt, wenn das Druckelement (72) gleichzeitig als Deckel des Leistungshalbleitermoduls (1) dient.

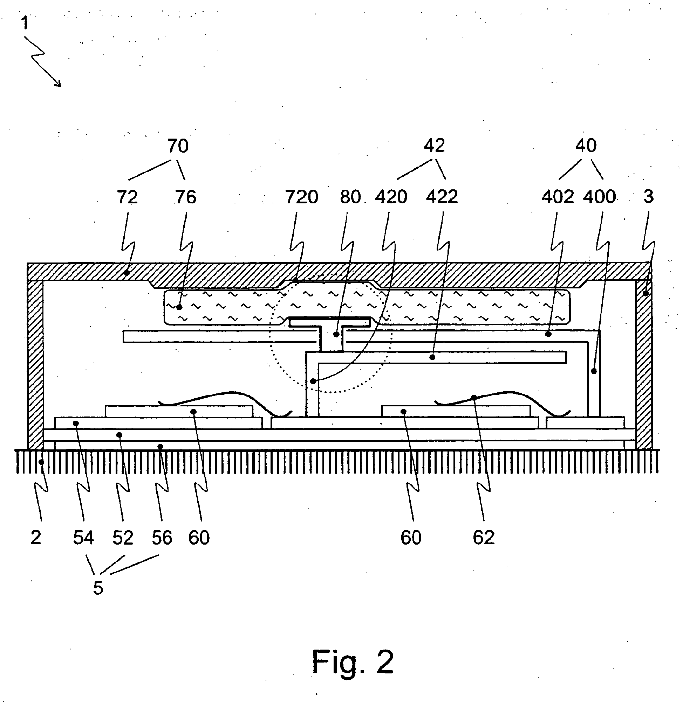

Fig. 2 zeigt einen Schnitt durch eine erste Ausgestaltung eines erfindungsgemäßen Leistungshalbleitermoduls (1) mit grundlegender Konstruktion gemäß Fig. 1. Dargestellt ist wiederum das Substrat (5) mit Leistungshalbleiterbauelementen (60) und dem Gehäuse (3). Aus Gründen der Übersichtlichkeit wurde allerdings ohne Beschränkung auf diese Ausführungsform auf die Zwischenlage (30) und eines der drei Lastanschlusselemente (44) verzichtet. Die nach außen führenden Lastanschlusselemente (40, 42) sind wiederum als Metallformkörper mit einem bandartigen Abschnitt (402, 422) und mit von diesem ausgehenden Kontaktfüßen (400, 420) ausgebildet. Hierbei ist der jeweilige bandartige Abschnitt (402, 422) parallel zur Substratoberfläche und von dieser beabstandet angeordnet. Die Kontaktfüße (400, 420) reichen von dem bandartigen Abschnitt (402, 422) zum Substrat (5) und kontaktieren dieses schaltungsgerecht.

Gemäß dem Stand der Technik ist hierzu eine Druckeinrichtung angeordnet, die aus einem Druck aufbauenden Druckstück (72) und ein zwischen diesem Druckstück (72) und dem ersten Lastanschlusselement (40) angeordneten dauerelastischen Kissenelement (76) als Druckspeicher. Somit wird auf das erste Lastanschlusselement Druck eingeleitet und eine sichere elektrische Kontaktierung mit dem Substrat hergestellt. Ebenso wird eine thermische Kontaktierung zwischen dem Substrat und dem Kühlbauteil erreicht.

Zur ebenso sicheren elektrischen Kontaktierung des zweiten Lastanschlusselements (42) weist die das Leistungshalbleitermodul nach Fig. 1 mindestens einen Druckkörper (80) angeordnet zwischen der Druckeinrichtung (70) und einem zweiten Lastanschlusselement (42) auf. Hierbei reicht in der erfindungsgemäßen Weiterbildung ein Teil dieses Druckkörpers (80) durch eine Ausnehmung (406) des ersten Lastanschlusselements (40) im Bereich des bandartigen Abschnitts (402) hindurch und leitet somit den durch die Druckeinrichtung erzeugten Druck direkt auf eine Druckaufnahmestelle des zugeordneten zweiten Lastanschlusselements.

Es ist besonders vorteilhaft, wenn das Druckstück (72) der Druckeinrichtung (70) auf der dem Inneren des Leistungshalbleitermoduls (1) zugewandten Seite Ausformungen (720) aufweist, die der Kontur des bandartigen Abschnitts (402) und des Druckkörpers (80) im Wesentlichen folgt. Hierdurch kann sichergestellt werden, dass das Kissenelement (76) über seine gesamte Fläche einer homogenen Kompression unterliegt.

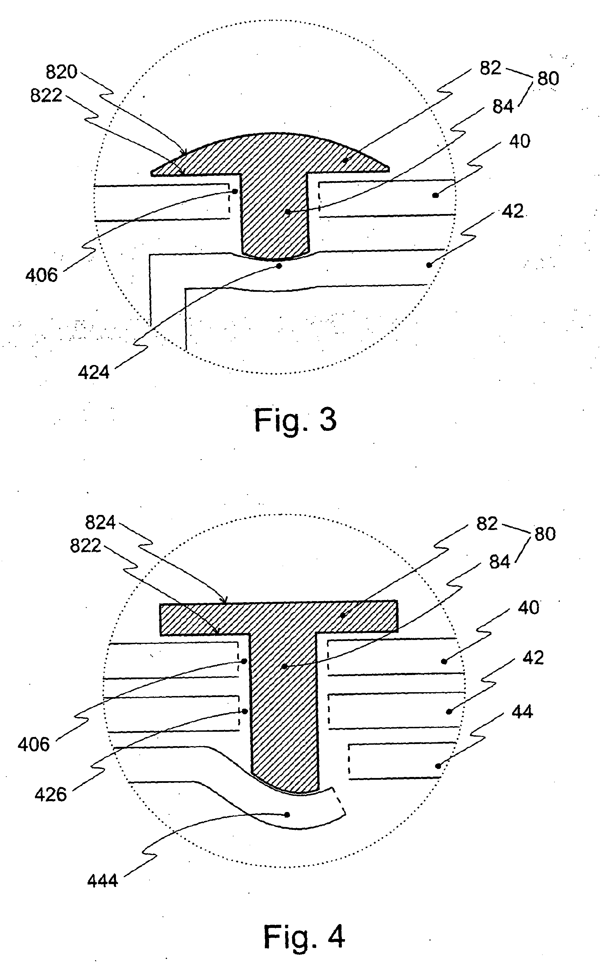

Fig. 3 zeigt einen Ausschnitt (gestrichelte Linie) gemäß Fig. 2 einer zweiten Ausgestaltung eines erfindungsgemäßen Leistungshalbleitermoduls (1). Dargestellt ist hier ausschließlich der Druckkörper und seine Anordnung zum ersten und einem weiteren, zweiten, Lastanschlusselement.

Der Druckkörper (80) selbst ist hierbei als T- förmiges, vorzugsweise aus Kunststoff ausgebildetes, Formteil ausgestaltet. Dieses weist einen Druck aufnehmenden Druckteller (82) und einen den Druck auf das weitere Lastanschlusselement (42) ausübenden Druckzapfen (84) auf. Der Druck wird hierbei vorzugsweise wie in Fig. 2 dargestellt mittels eines Kissenelements (76) gleichzeitig auf den Druckteller (82) wie auch auf das erste Lastanschlusselement (40) eingeleitet. Durch geeignete Länge des Druckzapfens (84) wird der Druck auf den Druckteller (82) über den Druckzapfen (84) auf das zweite Lastanschlusselement (42), nicht aber auf das erste Lastanschlusselement (40) eingeleitet. Da weiterhin beide Lastanschlusselemente (40) voneinander beabstandet sind ist die Druckeinleitung auf beide unabhängig voneinander.

Wie hier dargestellt kann es vorteilhaft sein, wenn der Druckteller (82) des Druckkörpers (80) plan- konvex ausgebildet ist, wobei die konvexe Fläche (820) der Druckeinrichtung (70) und die plane Fläche (822) dem ersten Lastanschlusselement (40) zugewandt ist.

Weiterhin kann es vorteilhaft sein die Druckaufnahmestelle (424) der weiteren Kontakteinrichtung (42) im Bereich des bandartigen Abschnitts (422) als prägetechnisch hergestellte Vertiefung auszubilden.

Fig. 4 zeigt einen Ausschnitt (gestrichelte Linie) gemäß Fig. 2 einer dritten Ausgestaltung eines erfindungsgemäßen Leistungshalbleitermoduls (1). Hierbei sind drei Lastanschlusselemente (40, 42, 44) dargestellt, wobei hier der Druck auf das dritte Lastanschlusselement (40) ausgeübt wird.

Hierzu ist der Druckkörper (80) wiederum als T- förmiges Kunststoffformteil ausgebildet, wobei allerdings der Druckteller (82) des Druckkörpers (80) zwei plane und zueinander parallele Flächen (824, 822) aufweist. Dabei ist die erste Fläche (824) der Druckeinrichtung (70) und die zweite Fläche (822) dem ersten Lastanschlusselement (40) zugewandt.

Es kann ebenso vorteilhaft sein die Druckaufnahmestelle (444) der weiteren Kontakteinrichtung (44) im Bereich des bandartigen Abschnitts (442) als stanzbiegetechnisch hergestellte Aufnahmenase auszubilden.

Zur elektrischen Isolierung der Lastanschlusselemente zueinander sind Isolationszwischenlagen in Ausgestaltung von Isolationsfolien nach dem Stand der Technik geeignet angeordnet. Es kann auch bevorzugt sein zur Isolation die Lastanschlusselemente (40, 42, 44) geeignet mit einem Isolierstoff, wie Kunststoff oder Keramik, zu umhüllen.

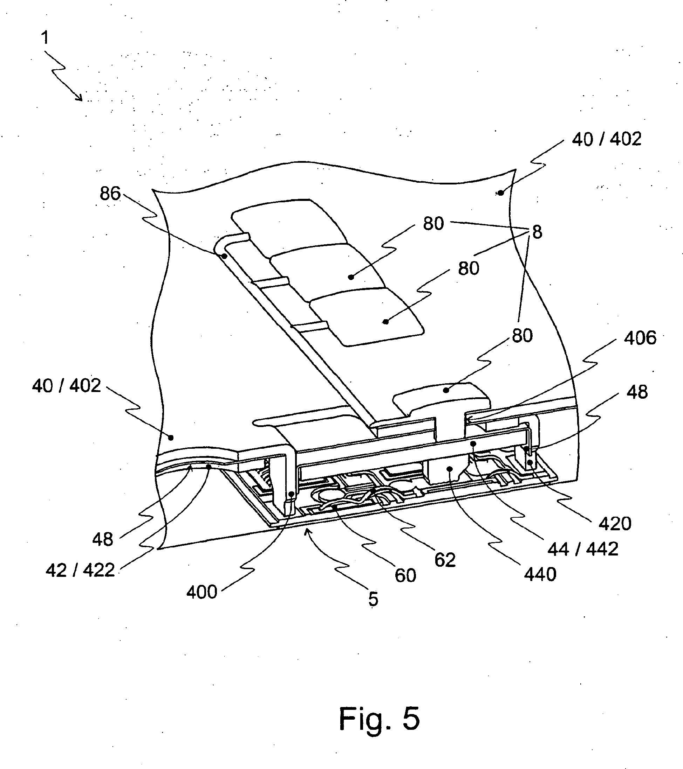

Fig. 5 zeigt in dreidimensionaler Darstellung einen Ausschnitt eines erfindungsgemäßen Leistungshalbleitermoduls. Dargestellt ist das Substrat (5) mit hierauf schaltungsgerecht angeordneten und mittels Drahtbondverbindungen (62) verbundenen Leistungshalbleiterbauelementen (60).

Die Lastanschlusselemente (40, 42, 44) weisen wie bereits oben beschrieben parallel zum Substrat angeordnete bandartige Abschnitte (402, 422, 442) auf, die hier mittels Isolationsfolien (48) elektrisch voneinander isoliert angeordnet sind. Die dem jeweiligen Lastanschlusselement (40, 42, 44) zugeordneten Kontaktfüße (400, 420, 440) sind in Stanz- Biegetechnik hergestellt und dienen der elektrischen Verbindung zum Substrat.

Die hierfür notwendige nicht dargestellte Druckeinrichtung drückt einerseits auf den bandartigen Abschnitt (402) des Lastanschlusselements (40) sowie mittels der Druckkörper (80) auf die näher am Substrat angeordneten Lastanschlusselemente, hier nur dargestellt auf das dritte Lastanschlusselement (44). Hierzu weist die Isolationsfolie (48) vorzugsweise keine Ausnehmung auf, da somit die gesamte elektrische Isolierung nicht beeinträchtigt wird.

Es kann besonders bevorzugt sein, wenn eine Mehrzahl von Druckkörpern (80) im Bereich der Druckteller (80) mittels Stegen (86) verbunden ist und diese somit eine Montageeinheit (8) bilden.

## Patentansprüche

1. Leistungshalbleitermodul (1) in Druckkontaktausführung mit mindestens einem Substrat (5), hierauf angeordneten Leistungshalbleiterbauelementen (60), einem Gehäuse (3) und nach außen führenden Lastanschlusselementen (40, 42, 44) und mit einer Druckeinrichtung (70) mit mindestens einem Druckkörper (80), wobei das Substrat (5) auf seiner ersten dem Inneren des Leistungshalbleitermoduls zugewandten Hauptfläche Leiterbahnen (54) mit Lastpotential aufweist,
**dadurch gekennzeichnet dass** ein erstes (40) und mindestens ein weiteres (42, 44) Lastanschlusselement jeweils als Metallformkörper mit einem bandartigen Abschnitt (402, 422, 442) und mit von diesem ausgehenden Kontaktfüßen (400, 420, 440) ausgebildet ist, der jeweilige bandartige Abschnitt (402, 422, 442) parallel zur Substratoberfläche und von dieser beabstandet angeordnet ist und die Kontaktfüße (400, 420, 440) von dem bandartigen Abschnitt (402, 422, 442) zum Substrat (5) reichen und dieses schaltungsgerecht kontaktieren, und
dass der mindestens eine Druckkörper (80) zwischen der Druckeinrichtung (70) und einem weiteren Lastanschlusselement (42, 44) angeordnet ist, wobei ein Teil dieses Druckkörpers (80) durch das erste Lastanschlusselement (40) hindurch reicht und Druck auf eine Druckaufnahmestelle (424, 444) des zugeordneten weiteren Lastanschlusselement (42, 44) ausbildet.

2. Leistungshalbleitermodul (1) nach Anspruch 1,
wobei der Druckkörper (80) durch eine Ausnehmung (406) des ersten Lastanschlusselements (40) im Bereich des bandartigen Abschnitts (402) hindurch reicht.

3. Leistungshalbleitermodul (1) nach Anspruch 1,
wobei der Druckkörper (80) als T- förmiges Kunststoffformteil ausgebildet ist mit einem Druck aufnehmenden Druckteller (82) und einen Druck auf das weitere Lastanschlusselement (42, 44) ausübenden Druckzapfen (84).

4. Leistuhgshalbleitermödul (1) nach Anspruch 3,
wobei der Druckteller (82) des Druckkörpers (80) zwei plane zueinander parallele Flächen (820, 822) aufweist, wobei die erste (820) der Druckeinrichtung (70) und die zweite (822) dem ersten Lastanschlusselement (40) zugewandt ist.

5. Leistungshalbleitermodul (1) nach Anspruch 3,
wobei der Druckteller (82) des Druckkörpers (80) plan-konvex ausgebildet ist, wobei die konvex Fläche (824) der Druckeinrichtung (70) und die plane Fläche (822) dem ersten Lastanschlusselement (40) zugewandt ist.

6. Leistungshalbleitermodul (1) nach Anspruch 1,
wobei einer Mehrzahl von Druckkörpern (80) im Bereich der Druckteller (82) verbunden sind und somit eine Montageeinheit (8) bilden.

7. Leistungshalbleitermodul (1) nach Anspruch 1,
wobei die Druckaufnahmestelle (424, 444) der weiteren Kontakteinrichtung (42, 44) im Bereich des bandartigen Abschnitts (422, 442) als prägetechnisch hergestellte Vertiefung ausgebildet ist.

8. Leistungshalbleitermodul (1) nach Anspruch 1,
wobei die Druckaufnahmestelle (424, 444) der weiteren Kontakteinrichtung (42, 44) im Bereich des bandartigen Abschnitts (422, 442) als stanz- biegetechnisch hergestellte Aufnahmenase ausgebildet ist.

9. Leistungshalbleitermodul (1) nach Anspruch 1,
wobei die Druckeinrichtung (70) ausgebildet ist als ein aufbauendes Druckstück (72) und ein zwischen diesem Druckstück (72) und dem ersten Lastanschlusselement (40) und dem Druckkörper (80) angeordnetes dauerelastisches Kissenelement (76) als Druckspeicher.

10. Leistungshalbleitermodul (1) nach Anspruch 1
wobei die Lastanschlusselemente (40, 42, 44) teilweise mit einem Isolierstoff, wie Kunststoff oder Keramik; umhüllt sind.

## Claims

1. A power semiconductor module (1) in pressure contact design, comprising at least one substrate (5), power semiconductor components (60) disposed thereon, a housing (3) and outwardly-leading load connection elements (40, 42, 44) and comprising a pressure device (70) with at least one pressure body (80), wherein the substrate (5) comprises conductor paths (54) at load potential disposed on the first principal surface thereof, facing the interior of the power semiconductor module, **characterised in that** a first (40) and at least one further (42, 44) load connection element are each configured as metal shaped bodies having a strip-shaped section (402, 422, 442) and contact feet (400, 420, 440) emanating therefrom, the respective strip-shaped section (402, 422, 442) is disposed parallel to the substrate surface and at a distance therefrcm, and the contact feet (400, 420, 440) extend from the strip-shaped section (402, 422, 442) to the substrate (5) and contact this in a manner appropriate to the circuit, and that the at least one pressure body (80) is disposed between the pressure device (7C) and a further load connection element (42, 44), wherein a part of this pressure body (80) extends through the first load connection element (40) and produces pressure on a pressure-receiving point (424, 444) of the allocated further load connection element (42, 44).

2. The power semiconductor module (1) according to claim 1, wherein the pressure body (80) expends through a recess (406) of the first load connection element (40) in the area of the strip-shaped section (402).

3. The power semiconductor module (1) according to claim 1, wherein the pressure body (80) is configured as a T-shaped plastic moulding comprising a pressure plate (82) which receives a pressure and a pressure pin (84) which exerts pressure on the further load connection element (42, 44).

4. The power semiconductor module (1) according to claim 3, wherein the pressure plate (82) of the pressure body (80) comprises two plane parallel surfaces (820, 822), wherein the first (820) faces the pressure device (70) and the second (822) faces the first load connection element (40).

5. The power semiconductor module (1) according to claim 3, wherein the pressure plate (82) of the pressure body (80) is configured to be plano-convex, wherein the convex surface (824) faces the pressure device (70) and the plane surface (822) faces the first load connection element (40).

6. The power semiconductor module (1) according to claim 1, wherein a plurality of pressure bodies (80) are connected in the area of the pressure plate (82) and thus form an assembly unit (8).

7. The power semiconductor module (1) according to claim 1, wherein the pressure receiving point (424, 444) of the further contact device (42, 44) in the area of the strip-shaped section (422, 442) is configured as a recess produced by embossing technology.

8. The power semiconductor module (1) according to claim 1, wherein the pressure receiving point (424, 444) of the further contact device (42, 44) in the area of the strip-shaped section (422, 442) is configured as a receiving lug produced by stamping bending technology.

9. The power semiconductor module (1) according to claim 1, wherein the pressure device (70) is configured as a developing pressure piece (72) and a permanent elastic cushion element (76) disposed between this pressure piece (72) and the first load connection element (40) and the pressure body (80) is configured as a pressure storage device.

10. The power semiconductor module (1) according to claim 1, wherein the load connection elements (40, 42, 44) are partially enclosed with insulating material such as plastic or ceramic.

## Revendications

1. Module semiconducteur de puissance (1), en configuration avec contacts par pression, avec au moins un substrat (5), des composants semiconducteurs de puissance (60) disposés sur celui-ci, un boîtier (3) et des éléments de raccordement de charge (40, 42, 44) conduisant vers l'extérieur, et avec un dispositif de pression (70) comprenant au moins un corps de pression (80), dans lequel le substrat (5) présente sur sa première surface principale, tournée vers l'intérieur du module semiconducteur de puissance, des pistes conductrices (54) ayant un potentiel de charge,
**caractérisé en ce qu'**un premier (40) et au moins un second (42, 44) élément de raccordement de charge est réalisé sous la forme d'un corps métallique moulé, avec un segment en forme de ruban (402, 422, 442) et des pattes de contact (400, 420, 440) partant de ce dernier, **en ce que** les différents segments en forme de ruban sont parallèles à la surface du substrat et sont écartés de celle-ci, **en ce que** les pattes de contact (400, 420, 440) partent du segment en forme de ruban (402, 422, 442) et s'étendent jusqu'au substrat (5) et réalisent des contacts conformes au circuit, et
**en ce que** ledit au moins un corps de pression (80) est disposé entre le dispositif de pression (70) et un autre élément de raccordement de charge (42, 44), si bien qu'une partie de ce corps de pression (80) traverse le premier élément de raccordement de charge (40) et exerce une pression sur un point d'application de pression (424, 444) de l'autre élément de raccordement de charge (42, 44) qui lui correspond.

2. Module semiconducteur de puissance (1) selon la revendication 1, dans lequel le corps de pression (80) passe au travers d'un évidement (406) du premier élément de raccordement de charge (40), au niveau du segment en forme de ruban (402).

3. Module semiconducteur de puissance (1) selon la revendication 1, dans lequel le corps de pression (80) est réalisé comme une pièce moulée en plastique en forme de T, avec un plateau de pression (82) encaissant une pression et avec un téton de pression (84) exerçant la pression sur l'autre élément de raccordement de charge (42, 44).

4. Module semiconducteur de puissance (1) selon la revendication 3, dans lequel le plateau de pression (82) du corps de pression (80) possède deux surfaces planes parallèles entre elles (820, 822), la première (820) étant tournée vers le dispositif de pression (70) et la seconde (822) vers le premier élément de raccordement de charge (40).

5. Module semiconducteur de puissance (1) selon la revendication 3, dans lequel le plateau de pression (82) du corps de pression possède une configuration plane convexe, la surface convexe (824) étant tournée vers le dispositif de pression (70) et la surface plane (822) vers le premier élément de raccordement de charge (40).

6. Module semiconducteur de puissance (1) selon la revendication 1, dans lequel une pluralité de corps de pression (80) sont reliés au niveau des plateaux de pression (82) et constituent ainsi une unité de montage (8).

7. Module semiconducteur de puissance (1) selon la revendication 1, dans lequel le point d'application de pression (424, 444) de l'autre dispositif de contact (42, 44) est réalisé au niveau du segment en forme de ruban (422, 442) sous la forme d'une dépression réalisée par une technologie de matriçage.

8. Module semiconducteur de puissance (1) selon la revendication 1, dans lequel le point d'application de pression (424, 444) de l'autre dispositif de contact (42, 44) est réalisé au niveau du segment en forme de ruban (422, 442) sous la forme d'un mentonnet d'application de charge réalisé par une technologie d'estampage et de pliage.

9. Module semiconducteur de puissance (1) selon la revendication 1, dans lequel le dispositif de pression (70) est réalisé sous la forme d'une pièce de pression (72) structurelle et dans lequel un élément de coussin (76) durablement élastique disposé entre cette pièce de pression (72), le premier élément de raccordement de pression (40) et le corps de pression (80), joue le rôle d'accumulateur de pression.

10. Module semiconducteur de puissance (1) selon la revendication 1, dans lequel les éléments de raccordement de charge (40, 42, 44) sont partiellement enveloppés d'une matière isolante, par exemple une matière plastique ou une céramique.
